(19) 

Europäisches
Patentamt
European
Patent Office
Office européen
des brevets

(11) **EP 4 679 111 A1**

(12) **EUROPEAN PATENT APPLICATION**
published in accordance with Art. 153(4) EPC

(43) Date of publication:
**14.01.2026  Bulletin 2026/03**

(21) Application number: **24785032.4**

(22) Date of filing: **14.02.2024**

(51) International Patent Classification (IPC):
*G01R 31/36* (2020.01)     *G01R 31/392* (2019.01)
*G01R 31/396* (2019.01)     *G01R 31/382* (2019.01)

(52) Cooperative Patent Classification (CPC):
**G01R 31/36; G01R 31/382; G01R 31/392;
G01R 31/396**

(86) International application number:
**PCT/KR2024/002076**

(87) International publication number:
**WO 2024/210321 (10.10.2024 Gazette 2024/41)**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**GE KH MA MD TN**

(30) Priority:  **07.04.2023  KR 20230045996**

(71) Applicant: **LG Energy Solution, Ltd.
Seoul 07335 (KR)**

(72) Inventors:
• **JANG, Jin Woo
  Daejeon 34122 (KR)**
• **KIM, Ki Hoon
  Daejeon 34122 (KR)**
• **JUNG, Jin Won
  Daejeon 34122 (KR)**

(74) Representative: **Plasseraud IP
104 Rue de Richelieu
CS92104
75080 Paris Cedex 02 (FR)**

(54) **BATTERY DIAGNOSIS DEVICE AND OPERATION METHOD THEREOF**

(57)     battery diagnosis apparatus for diagnosing whether a battery is defective includes a processor and a memory storing a plurality of instructions, in which the instructions cause, when executed by the processor, the battery diagnosis apparatus, to calculate an SOH deviation dSOH between an SOH in a designated cycle and an average SOH in the designated cycle, for each of a plurality of battery cells, calculate first difference values $\Delta$dSOH between SOH deviations dSOH in different cycles for each of the plurality of battery cells, calculate second difference values SOHdt between SOH values in the different cycles for each of the plurality of battery cells, calculate an error bound of each of the plurality of battery cells based on the first difference values and the second difference values, and diagnose whether each of the plurality of battery cells is defective, based on the error bound.

FIG.1

EP 4 679 111 A1

**Description**

**[Technical Field]**

CROSS-REFERENCE TO RELATED APPLICATION

This application claims priority to and the benefit of Korean Patent Application No. 10-2023-0045996 filed in the Korean Intellectual Property Office on April 7, 2023, the entire content of which is incorporated herein by reference.

TECHNICAL FIELD

Embodiments disclosed herein relate to a battery diagnosis apparatus and an operating method thereof.

**[Background Art]**

Recently, research and development of secondary batteries have been actively performed. Herein, the secondary batteries, which are chargeable/dischargeable batteries, may include all of conventional nickel (Ni)/cadmium (Cd) batteries, Ni/metal hydride (MH) batteries, etc., and recent lithium-ion batteries. Among the secondary batteries, a lithium-ion battery has a much higher energy density than those of conventional Ni/Cd batteries, Ni/MH batteries, etc. Moreover, the lithium-ion battery may be manufactured to be small and lightweight, such that the lithium-ion battery has been used as a power source of mobile devices, and recently, a use range thereof has been extended to power sources for electric vehicles, attracting attention as next-generation energy storage media.

Battery safety testing is required not only during a battery production process but also for batteries in use. Defective batteries may be produced due to errors in the production process, and even batteries produced normally may become defective while being used. Batteries are used in a variety of industrial fields, such that the use of a defective battery may lead to an explosion, resulting in property damage and casualties.

There are various types of defects in batteries, but a representative defect is a defect caused by an electrode bridge phenomenon. The electrode bridge phenomenon refers to a state in which due to a weak adhesive force between an electrode and a collector or electrodes of a battery, the electrode is separated in the shape of a bar and thus a positive electrode and a negative electrode are connected in a battery cell.

**[Disclosure]**

**[Technical Problem]**

An electrode bridge phenomenon may be detected by a Hi-pot test carried out in a battery assembly process or a low-voltage type test in an activation process. For example, an existing method of detecting a defective battery due to an electrode bridge is carried out on a module basis, and data regarding battery cells in a module may be compared to detect a defective battery.

However, according to the existing method, an SOH estimation value is not accurately measured due to noises generated in a process of estimating an SOH of the battery.

Moreover, in a battery manufacturing/assembling process, an electrode bridge phenomenon may occur in a battery classified as a normal battery during use of the battery.

Technical problems of the embodiments disclosed herein are not limited to the above-described technical problems, and other unmentioned technical problems would be clearly understood by one of ordinary skill in the art from the following description.

**[Technical Solution]**

A battery diagnosis apparatus for diagnosing whether a battery is defective includes a processor and a memory storing a plurality of instructions, in which the instructions cause, when executed by the processor, the battery diagnosis apparatus, to calculate a state of health (SOH) deviation dSOH between an SOH in a designated cycle and an average SOH in the designated cycle, for each of a plurality of battery cells, calculate first difference values $\Delta$dSOH between SOH deviations dSOH in different cycles for each of the plurality of battery cells, calculate second difference values SOHdt between SOH values in the different cycles for each of the plurality of battery cells, calculate an error bound of each of the plurality of battery cells based on the first difference values and the second difference values, and diagnose whether each of the plurality of battery cells is defective, based on the error bound.

In an embodiment, a $k^{th}$ first difference value $\Delta$dSOH$_k$ among the first difference values may be an absolute value of a difference between an SOH deviation $dSOH_k$ in a $k^{th}$ cycle and an SOH deviation $dSOH_{k-1}$ in a $(k-1)^{th}$ cycle, k may be an integer between 1 and n, n may be an integer number of 1 or greater, and a $0^{th}$ cycle may be the latest cycle.

In an embodiment, a $p^{th}$ second difference value $SOHdt_p$ among the second difference values may be a difference value between an SOH $SOH_p$ in a $(p-1)^{th}$ cycle and an SOH $SOH_{p-l}$ in a $p^{th}$ cycle, p may be an integer between 1 and m, m may be an integer number of 1 or greater, the $0^{th}$ cycle may be the latest cycle, and a $(m+1)^{th}$ second difference value $SOHdt_{m+1}$ may be a difference value between $SOH_0$ in a $0^{th}$ cycle and the $SOH_m$ in an $m^{th}$ cycle.

In an embodiment, the instructions may cause, when executed by the processor, the battery diagnosis apparatus, to determine the $p^{th}$ second difference value $SOHd_{tp}$ as 0 when the $p^{th}$ second difference value $SOHd_{tp}$ is a negative value.

In an embodiment, the instructions may cause, when executed by the processor, the battery diagnosis apparatus, to calculate a plurality of weights based on the second difference values and calculate the error bound based on the weights and the first difference values.

In an embodiment, the instructions may cause, when executed by the processor, the battery diagnosis apparatus, to calculate a dot product of the weights and the first difference values, calculate a sum of the first difference values and a product of the weights, and calculate the error bound by adding the calculated dot product and the calculated product.

In an embodiment, the battery diagnosis apparatus may further include a communication circuit, in which the instructions may cause, when executed by the processor, the battery diagnosis apparatus, to transmit a result of the diagnosis to a user terminal through the communication circuit.

An operating method of a battery diagnosis apparatus includes calculating a state of health (SOH) deviation dSOH between an SOH in a designated cycle and an average SOH in the designated cycle, for each of a plurality of battery cells, calculating first difference values ΔdSOH between SOH deviations dSOH in different cycles for each of the plurality of battery cells, calculating second difference values SOHdt between SOH values in the different cycles for each of the plurality of battery cells, calculating an error bound of each of the plurality of battery cells based on the first difference values and the second difference values, and diagnosing whether each of the plurality of battery cells is defective, based on the error bound.

In an embodiment, a $k^{th}$ first difference value $\Delta dSOH_k$ among the first difference values may be an absolute value of a difference between an SOH deviation $dSOH_k$ in a $k^{th}$ cycle and an SOH deviation $dSOH_{k-1}$ in a $(k-1)^{th}$ cycle, k may be an integer between 1 and n, n may be an integer number of 1 or greater, and a $0^{th}$ cycle may be the latest cycle.

In an embodiment, a $p^{th}$ second difference value $SOHdt_p$ among the second difference values may be a difference value between an SOH $SOH_p$ in a $(p-1)^{th}$ cycle and an SOH $SOH_{p-l}$ in a $p^{th}$ cycle, p may be an integer between 1 and m, m may be an integer number of 1 or greater, the $0^{th}$ cycle may be the latest cycle, and a $(m+1)^{th}$ second difference value $SOHdt_{m+1}$ may be a difference value between $SOH_0$ in a $0^{th}$ cycle and the $SOH_m$ in an $m^{th}$ cycle.

In an embodiment, the operating method may further include determining the $p^{th}$ second difference value $SOHdt_p$ as 0 when the $p^{th}$ second difference value $SOHdt_p$ is a negative value.

In an embodiment, the calculating of the error bound of each of the plurality of battery cells based on the first difference values and the second difference values may include calculating a plurality of weights based on the second difference values and calculating the error bound based on the weights and the first difference values.

In an embodiment, the calculating of the error bound based on the weights and the first difference values may include calculating a dot product of the weights and the first difference values, calculating a sum of the first difference values and a product of the weights, and calculating the error bound by adding the calculated dot product and the calculated product.

In an embodiment, the operating method may further include transmitting the diagnosis result to a user terminal.

**[Advantageous Effects]**

The battery diagnosis apparatus and the operating method thereof according to various embodiments disclosed herein may detect a defective battery caused by an electrode bridge even when a change rate of an SOH sharply decreases within a short time and/or continuously decreases slowly.

Moreover, the battery diagnosis apparatus and the operating method thereof according to various embodiments disclosed herein may accurately detect a defective battery cell caused by an electrode bridge even when SOH estimation is unstable (including excessive noise) on a system.

Accordingly, the battery diagnosis apparatus and the operating method thereof according to various embodiments disclosed herein may perform defect diagnosis for each battery cell rather than each module merely using data about the battery cell.

Furthermore, the battery diagnosis apparatus and the operating method thereof according to various embodiments disclosed herein may be mounted on a device using a battery cell, a battery management system, a charger, etc., thereby diagnosing whether a battery in use is defective due to an electrode bridge.

The effects of the battery diagnosis apparatus and the operating method thereof according to the disclosure of the present document are not limited to the effects mentioned above, and other effects not mentioned will be clearly understood by those of ordinary skill in the art according to the disclosure of the present document.

[Description of Drawings]

FIG. 1 is a block diagram of a battery diagnosis apparatus according to an embodiment of the present disclosure.
FIG. 2 illustrates an SOH graph and a dSOH graph with respect to a defective battery cell of a first type, according to an embodiment of the present disclosure.
FIG. 3 illustrates a method of detecting a defective battery cell of a first type based on graphs of a first difference value, a second difference value, and a weight, according to an embodiment of the present disclosure.
FIG. 4 illustrates an SOH graph and a dSOH graph with respect to a defective battery cell of a second type, according to an embodiment of the present disclosure.
FIG. 5 illustrates a method of detecting a defective battery cell of a second type based on graphs of a first difference value, a second difference value, and a weight, according to an embodiment of the present disclosure.
FIG. 6 is a flowchart showing an operating method of a battery diagnosis apparatus according to an embodiment of the present disclosure.

With regard to the description of the drawings, similar reference numerals may be used to refer to similar or related components.

[Mode for Invention]

Hereinafter, embodiments of the present disclosure will be described with reference to the accompanying drawings. However, the description is not intended to limit the present disclosure to particular embodiments, and it should be construed as including various modifications, equivalents, and/or alternatives according to the embodiments of the present disclosure.

It should be appreciated that embodiments of the present document and the terms used therein are not intended to limit the technological features set forth herein to a particular embodiment and include various changes, equivalents, or replacements for a corresponding embodiment. With regard to the description of the drawings, similar reference numerals may be used to refer to similar or related elements. It is to be understood that a singular form of a noun corresponding to an item may include one or more of the things, unless the relevant context clearly indicates otherwise.

As used herein, each of such phrases as "A or B," "at least one of A and B," "at least one of A or B," "A, B, or C," "at least one of A, B, and C," and "at least one of A, B, or C," may include any one of, or all possible combinations of the items enumerated together in a corresponding one of the phrases. Such terms as "1st", "2nd," "first", "second", "A", "B", "(a)", or "(b)" may be used to simply distinguish a corresponding component from another, and does not limit the components in other aspect (e.g., importance or order), unless mentioned otherwise.

Herein, it is to be understood that when an element (e.g., a first element) is referred to, with or without the term "operatively" or "communicatively", as "connected with", "coupled with", or "linked with", or "coupled to" or "connected to" to another element (e.g., a second element), it means that the element may be connected with the other element directly (e.g., wiredly or wirelessly), or indirectly (e.g., via a third element).

A method according to various embodiments disclosed herein may be included and provided in a computer program product. The computer program product may be traded as a product between a seller and a buyer. The computer program product may be distributed in the form of a machine-readable storage medium (e.g., compact disc read only memory (CD-ROM)), or be distributed (e.g., downloaded or uploaded) online via an application store, or between two user devices directly. If distributed online, at least part of the computer program product may be temporarily generated or at least temporarily stored in the machine-readable storage medium, such as memory of the manufacturer's server, a server of the application store, or a relay server.

According to embodiments disclosed herein, each component (e.g., a module or a program) of the above-described components may include a single entity or multiple entities, and some of the multiple entities may be separately disposed in different components. According to various embodiments disclosed herein, one or more of the above-described components may be omitted, or one or more other components may be added. Alternatively or additionally, a plurality of components (e.g., modules or programs) may be integrated into a single component. In such a case, according to various embodiments, the integrated component may still perform one or more functions of each of the plurality of components in the same or similar manner as they are performed by a corresponding one of the plurality of components before the integration. According to embodiments disclosed herein, operations performed by the module, the program, or another component may be carried out sequentially, in parallel, repeatedly, or heuristically, or one or more of the operations may be executed in a different order or omitted, or one or more other operations may be added.

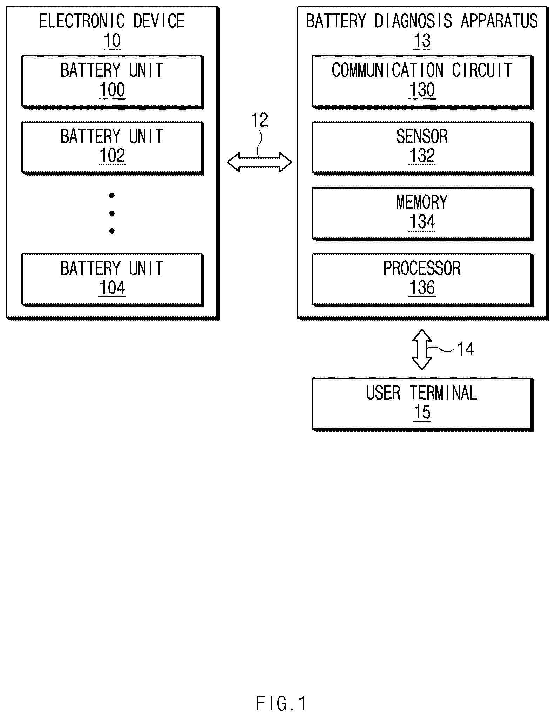

FIG. 1 is a block diagram of a battery diagnosis apparatus 13 according to an embodiment of the present disclosure.

Referring to FIG. 1, the battery diagnosis apparatus 13 may be wiredly and/or wirelessly connected to an electronic device 10 and a user terminal 15.

In an embodiment, the battery diagnosis apparatus 13 may be included in a battery management system (BMS), a charger, etc. In an embodiment, operations, performed by the battery diagnosis apparatus 13, of diagnosing a battery may be performed in a BMS, a server, a charger, etc., included in a device (e.g., a vehicle). Herein, the battery may refer to a battery cell, a battery module, a battery pack, or a battery rack.

In an embodiment, connection 12 between the battery diagnosis apparatus 13 and the electronic device 10 may be communication connection through a wired and/or wireless network. In an embodiment, the wired network may be based on a local area network (LAN) communication or a power-line communication. In an embodiment, the wireless network may be based on a short-range communication network (e.g., Bluetooth, Wireless Fidelity (WiFi), or Infrared Data Association (IrDA)) or a remote-range communication network (e.g., a cellular network, a $4^{th}$-Generation (4G) network, a $5^{th}$-Generation (5G) network).

In another embodiment, the connection 12 between the battery diagnosis apparatus 13 and the electronic device 10 may be connection using a device-to-device communication scheme (e.g., a bus, a general-purpose input and output (GPIO), a serial peripheral interface (SPI), or a mobile industry processor interface (MIPI)).

In an embodiment, connection 14 between the battery diagnosis apparatus 13 and the user terminal 15 may be communication connection through a wired and/or wireless network.

In an embodiment, the electronic device 10 may be a mobile device (e.g., a mobile phone, a laptop computer, a smart phone, a smart pad), an electric vehicle (e.g., an electric vehicle (EV), a hybrid EV (HEV), a plug-in HEV (PHEV), a fuel cell EV (FCEV)), an energy storage system (ESS), or a battery swapping system (BSS).

In an embodiment, the electronic device 10 may include one or more battery units 100, 102, and 104. Each of the one or more battery units 100, 102, and 104 may be a battery cell, a battery module, a battery pack, or a battery rack.

In an embodiment, the user terminal 15 may be a mobile device (e.g., a mobile phone, a laptop computer, a smart phone, a smart pad), or a personal computer (PC).

In an embodiment, the battery diagnosis apparatus 13 may include a communication circuit 130, a sensor 132, a memory 134, and a processor 136. According to an embodiment, the battery diagnosis apparatus 13 shown in FIG. 1 may further include at least one component (e.g., a display, an input device, or an output device) in addition to components shown in FIG. 1.

In an embodiment, the communication circuit 130 may establish a wired communication channel and/or a wireless communication channel between the battery diagnosis apparatus 13 and the electronic device 10 and/or the user terminal 15, and transmit and receive data to and from the electronic device 10 and/or the user terminal 15 through the established communication channel.

In an embodiment, the sensor 132 may obtain values related to states of the battery units of the electronic device 10. In an embodiment, values related to the states may indicate one or more values of voltages, currents, resistances, state of charge (SOC), SOH, or temperatures of the battery units or combinations thereof. Hereinbelow, the value related to the state may be referred to as a 'state value'.

The memory 134 may store a plurality of instructions. In an embodiment, the memory 134 may include a volatile and/or a nonvolatile memory. In an embodiment, the memory 134 may store data used by at least one component (e.g., the processor 136) of the battery diagnosis apparatus 13. For example, the data may include software (or an instruction related thereto), input data, or output data. In an embodiment, the instruction, when executed by the processor 136, may cause the battery diagnosis apparatus 13 to perform operations defined by the instruction. In an embodiment, the memory 134 may include one or more software.

The processor 136 may execute the instruction to control the battery diagnosis apparatus 13 to perform operations defined by the instructions. In an embodiment, the processor 136 may include a central processing unit, an application processor, a graphic processing unit, a neural processing unit (NPU), an image signal processor, a sensor hub processor, or a communication processor. In an embodiment, the processor 136 may execute software to control at least one other component (e.g., a hardware or software component) of the battery diagnosis apparatus 13 connected to the processor 136 and may process or compute various data.

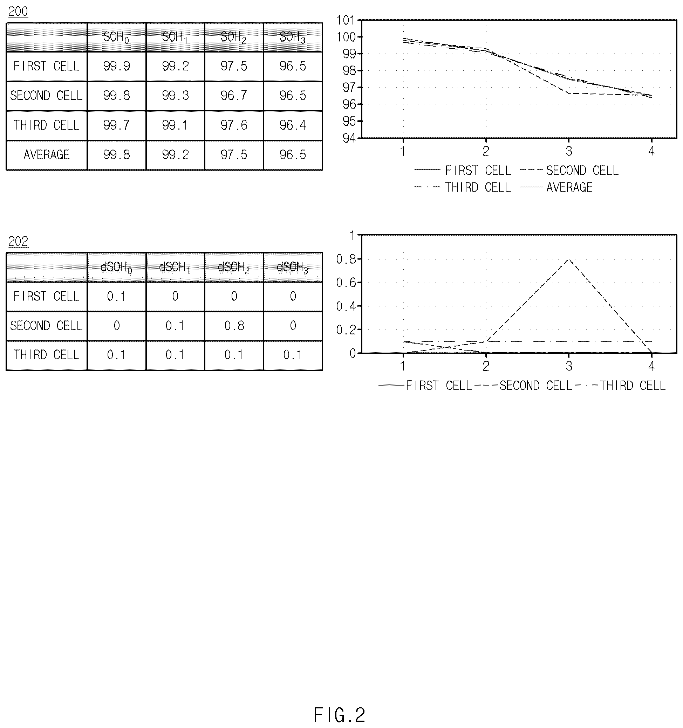

Hereinbelow, a method, performed by the battery diagnosis apparatus 13, of diagnosing whether each of the battery units 100, 102, and 104 is a defective battery due to an electrode bridge will be described with reference to FIGS. 2 to 6.

The battery diagnosis apparatus 13 may obtain SOH values of each battery cell. The battery diagnosis apparatus 13 may measure SOH values for each battery cell in a designated cycle through the sensor 132. The battery diagnosis apparatus 13 may obtain SOH values for each battery cell measured by the sensor 132.

The battery diagnosis apparatus 13 may calculate SOH deviations dSOH for each battery cell. Herein, the SOH deviation may be a difference between an SOH in a designated cycle and an average SOH of battery cells in the designated cycle for each of the battery cells. For example, a first SOH deviation for a first battery cell may be a difference between an SOH value in a first cycle and an average SOH value in the first cycle.

The battery diagnosis apparatus 13 may calculate first difference values $\Delta$dSOH between SOH deviations dSOH in different cycles for each of a plurality of battery cells. Herein, a $k^{th}$ first difference value $\Delta$dSOH$_k$ may be expressed as Equation 1.

$$[\text{Equation 1}]$$

$$\Delta dSOH_k = abs(dSOH_k - dSOH_{k-1})$$

Herein, abs(x) may be a function for calculating an absolute value of x. k may denote a variable indicating a $k^{th}$ cycle, and may be an integer between 1 and n. A $0^{th}$ cycle may be the latest cycle. The $0^{th}$ cycle may be the current cycle. The $k^{th}$ cycle may be a cycle preceding k cycles from the $0^{th}$ cycle. n may be an integer that is greater than or equal to 1. A sum $\Delta$dSOH$_{tot}$ of the first difference values may be a sum of a $1^{st}$ first difference value $\Delta$dSOH$_1$ to an $n^{th}$ first difference value $\Delta$dSOH$_n$.

The battery diagnosis apparatus 13 may calculate second difference values SOHdt between SOH values in different cycles for each of the plurality of battery cells. Herein, a $p^{th}$ second difference value may be expressed as Equation 2.

$$[\text{Equation 2}]$$

$$SOHdt_p = SOH_{p-1} - SOH_p$$

Herein, p may denote a variable indicating a $p^{th}$ cycle, and may be an integer between 1 and m. A $0^{th}$ cycle may be the latest cycle. The $0^{th}$ cycle may be the current cycle. The $p^{th}$ cycle may be a cycle preceding p cycles from the $0^{th}$ cycle. m may be an integer that is greater than or equal to 1. A $(m+1)^{th}$ second difference value SOHdt$_{m+1}$ may be a difference between the $0^{th}$ SOH SOH$_0$ and the $m^{th}$ SOH SOH$_m$. Herein, the $(m+1)^{th}$ second difference value SOHdt$_{m+1}$ may be expressed as Equation 3.

$$[\text{Equation 3}]$$

$$SOHdt_{m+1} = SOH_0 - SOH_m$$

The battery diagnosis apparatus 13 may determine the $p^{th}$ second difference value as 0 when the $p^{th}$ second difference value is a negative value. The battery diagnosis apparatus 13 may determine the greater value between the $p^{th}$ second difference value and 0 as a final $p^{th}$ second difference value, by using a max(x, y) function. Herein, the max(x, y) function may be a function that outputs the greater value between x and y.

The battery diagnosis apparatus 13 may calculate an error bound of each of the plurality of battery cells based on the first difference values and the second difference values.

As a first process for calculating an error bound, the battery diagnosis apparatus 13 may calculate a plurality of ratios based on the second difference values to calculate the error bound. Herein, a $p^{th}$ weight may be expressed as Equation 4.

$$[\text{Equation 4}]$$

$$ratio_p = \frac{SOHdt_p}{max(1, SOHdt_{m+1})}$$

Herein, p may denote a variable indicating the $p^{th}$ cycle, and may be an integer between 1 and m. The $0^{th}$ cycle may be the latest cycle. The $0^{th}$ cycle may be the current cycle. The $p^{th}$ cycle may be a cycle preceding p cycles from the $0^{th}$ cycle. m may be an integer that is greater than or equal to 1. A sum ratio$_{tot}$ of weights may be a sum of a first weight ratio$_l$ to an $m^{th}$ weight ratio$_m$.

As a second process for calculating the error bound, the battery diagnosis apparatus 13 may calculate the error bound based on the weights and the first difference values. The error bound may be calculated based on a first bound and a second bound based on the weights and the first difference values. The error bound may be calculated based on a sum of the first bound and the second bound. The first bound may be calculated based on a dot product of the first difference values and the weights. Herein, the first bound may be expressed as Equation 5.

[Equation 5]

$$\text{First Bound} = \Delta dSOH_1 * ratio_1 + \Delta dSOH_2 * ratio_2 + \ldots + \Delta dSOH_n * ratio_n$$

The second bound may be calculated based on a product of the sum of the first difference values and the sum of the weights. The second bound may be expressed as Equation 6.

[Equation 6]

$$\text{Second Bound} = \Delta dSOH_{tot} * ratio_{tot}$$

The battery diagnosis apparatus 13 may compare the error bound of each battery cell with a reference value. The battery diagnosis apparatus 13 may determine that a specific battery cell is a defective battery cell when an error bound of the specific battery cell exceeds the reference value. Herein, the reference value may be set by a setter, and may be set based on the error bound measured for normal battery cells.

The battery diagnosis apparatus 13 may transmit a diagnosis result to the user terminal 15. The battery diagnosis apparatus 13 may transmit a detection result to the user terminal 15 when a defective battery caused by an electrode bridge is detected. The battery diagnosis apparatus 13 may transmit a diagnosis result of classifying diagnosis target battery cells as normal battery cells or defective battery cells to the user terminal 15.

Hereinbelow, a method of detecting a defective battery cell due to an electrode bridge will be described with reference to FIGS. 2 to 5. A type of the electrode bridge is assumed to be a first type having a sharply decreasing SOH or a second type having a continuously decreasing SOH. However, this is merely an assumption for convenience of description, and the type of the electrode bridge is not limited thereto. For example, as a third type of the electrode bridge, there may be a type in which SOH continuously decreases, and sharply increases in a specific cycle. In addition, a description will be made assuming three battery cells and a designated cycle. However, this is merely an assumption for convenience of description, and the number of battery cells is not limited thereto.

FIG. 2 illustrates an SOH graph 200 and a dSOH graph 202 with respect to a defective battery cell of a first type, according to an embodiment of the present disclosure.

Referring to FIG. 2, a number on an x axis of the SOH graph 200 and the dSOH graph 202 may indicate a specific cycle in a designated cycle. A y axis of the SOH graph 200 may indicate an SOH value, and a y axis of the dSOH graph 202 may indicate a dSOH value.

The SOH graph 200 may include an SOH value for each of three battery cells in a designated cycle and an average SOH value in each cycle. In case of the second cell, when compared to the other cells (the first cell and the third cell), an SOH value in the third cycle rapidly decreases in comparison to an SOH value in the second cycle.

The dSOH graph 202 may include a difference value between the SOH value for each of the three battery cells and the average SOH value in a designated cycle. In case of the second cell, when compared to the other cells (the first cell and the third cell), a dSOH value in the third cycle rapidly changes in comparison to a dSOH value in the second cycle.

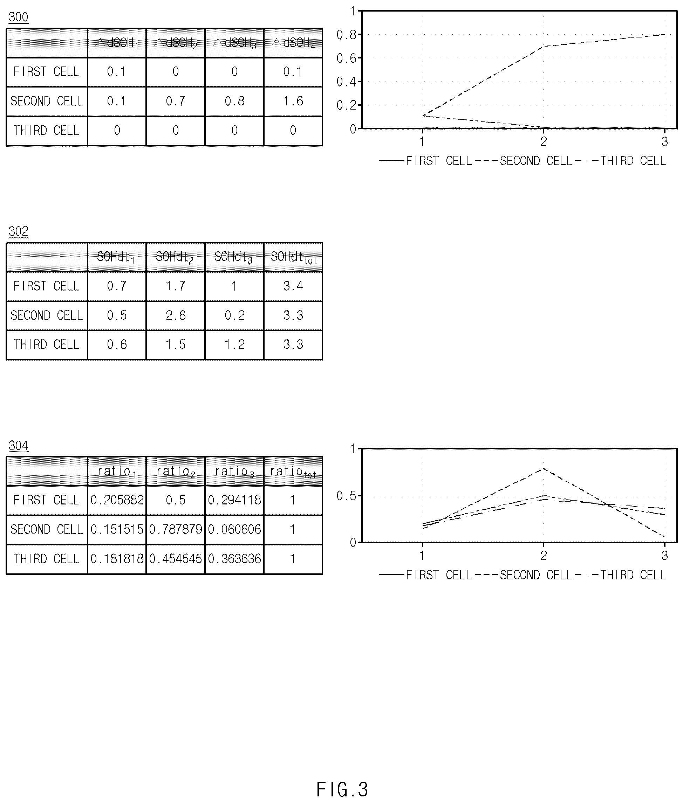

FIG. 3 illustrates a method of detecting a defective battery cell of a first type based on a first difference value graph 300, a second difference value graph 302, and a weight graph 304, according to an embodiment of the present disclosure.

Referring to FIG. 3, a number on an x axis of the first difference value graph 300 and the weight graph 304 may indicate a specific cycle in a designated cycle. A y axis of the first difference value graph 300 may indicate a first difference value, and a y axis of the weight graph 304 may indicate a weight value.

Referring to the first difference graph 300, the battery diagnosis apparatus 13 may calculate first difference values $\Delta dSOH$ between SOH deviations dSOH in different cycles for each of battery cells. For example, an absolute value of a difference between $dSOH_2$ and $dSOH_1$ of the first cell may be 0.7. For example, an absolute value $\Delta dSOH_4$ of a difference between $dSOH_3$ and $dSOH_0$ of the first cell may be 3.4.

Referring to the second difference graph 302, the battery diagnosis apparatus 13 may calculate second difference values SOHdt between SOH values in different cycles for each of battery cells (the first cell to the third cell). For example, a difference between $SOH_0$ and $SOH_1$ of the first cell may be 0.7. A difference between $SOH_1$ and $SOH_2$ of the second cell may be 2.6.

Referring to the weight graph 304, the battery diagnosis apparatus 13 may calculate a plurality of weights ratio. For example, the first weight $ratio_1$ of the first cell may be a value obtained by dividing the 1st second difference value

$SOHdt_1$ by a result of $max(1, SOHdt_4)$, and may equal 0.205882. A sum $ratio_{tot}$ of the weights of the first cell may be a sum of the first weight $ratio_1$ to the third weight $ratio_3$.

The battery diagnosis apparatus 13 may calculate an error bound of each of the first cell to the third cell, based on the first difference values and the weights.

The battery diagnosis apparatus 13 may diagnose whether the first cell to the third cell are normal batteries or defective batteries, by comparing the error bound of each of the first cell to the third cell with the reference value. For example, the reference value may be 2.00. The battery diagnosis apparatus 13 may calculate the error bound of the first cell as 0.120588. The battery diagnosis apparatus 13 may diagnose that the first cell as a normal battery because the error round of the first cell is less than or equal to the reference value. Meanwhile, the battery diagnosis apparatus 13 may calculate the error bound of the second cell as 2.215152. The battery diagnosis apparatus 13 may diagnose that the first cell as a defective battery because the error round of the second cell exceeds the reference value.

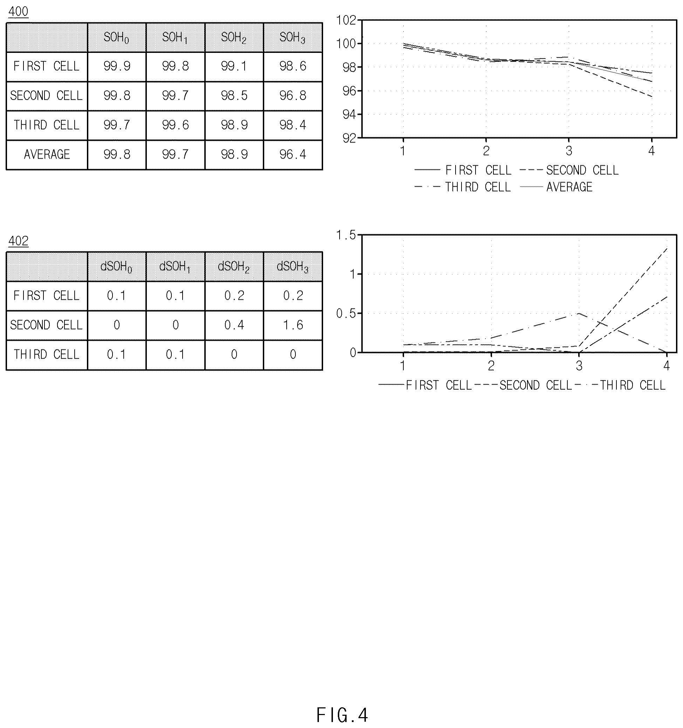

FIG. 4 illustrates graphs 400 and 402 of SOH and dSOH with respect to a defective battery cell of a second type, according to an embodiment of the present disclosure.

Referring to FIG. 4, a number on an x axis of the SOH graph 400 and the dSOH graph 402 may indicate a specific cycle in a designated cycle. A y axis of the SOH graph 400 may indicate an SOH value, and a y axis of the dSOH graph 402 may indicate a dSOH value.

The SOH graph 400 may include an SOH value for each of three battery cells in a designated cycle and an average SOH value in each cycle. In case of the second cell, when compared to the other cells (the first cell and the third cell), an SOH value continuously decreases.

The dSOH graph 402 may include a difference value between the SOH value for each of the three battery cells and the average SOH value in a designated cycle. In case of the second cell, when compared to the other cells (the first cell and the third cell), a dSOH value in a fourth cycle rapidly changes in comparison to a dSOH value in the third cycle.

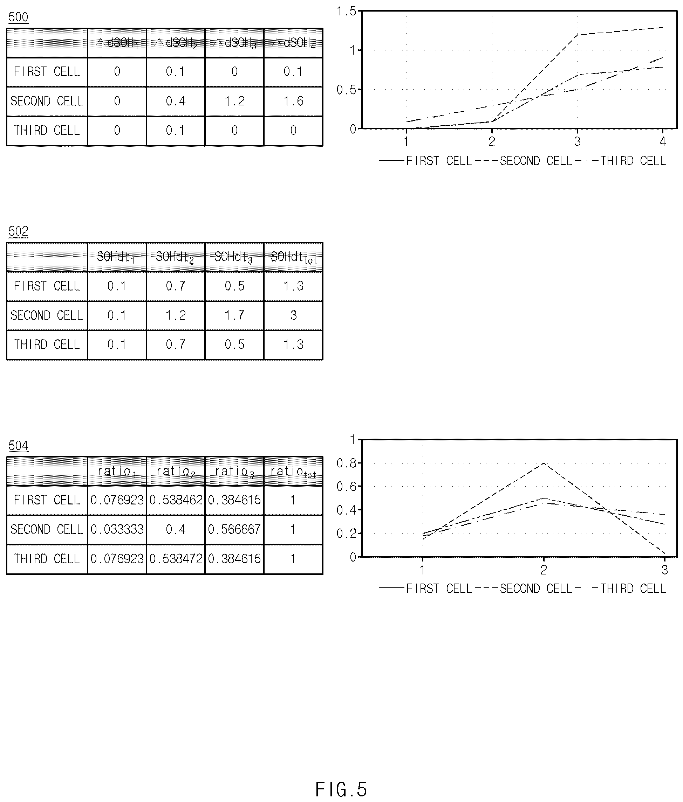

FIG. 5 illustrates a method of detecting a defective battery cell of a second type based on a first difference value graph 500, a second difference value graph 502, and a weight graph 504, according to an embodiment of the present disclosure.

Referring to FIG. 5, a number on an x axis of the first difference value graph 500 and the weight graph 504 may indicate a specific cycle in a designated cycle. A y axis of the first difference value graph 500 may indicate a first difference value, and a y axis of the weight graph 504 may indicate a weight value.

Referring to the first difference graph 500, the battery diagnosis apparatus 13 may calculate first difference values $\Delta dSOH$ between SOH deviations dSOH in different cycles for each of battery cells. For example, an absolute value of a difference between $dSOH_2$ and $dSOH_1$ of the first cell may be 0.7. For example, an absolute value $\Delta dSOH_4$ of a difference between $dSOH_3$ and $dSOH_0$ of the first cell may be 3.4.

Referring to the second difference graph 502, the battery diagnosis apparatus 13 may calculate second difference values SOHdt between SOH values in different cycles for each of battery cells (the first cell to the third cell). For example, a second difference value $SOHdt_2$ between $SOH_1$ and $SOH_2$ of the second cell may be 1.2.

Referring to the weight graph 504, the battery diagnosis apparatus 13 may calculate a plurality of weights ratio. For example, the second weight $ratio_2$ of the second cell may be a value obtained by dividing the 1st second difference value $SOHdt_2$ by a result of $max(1, SOHdt_4)$, and may equal 0.4. A sum $ratio_{tot}$ of the weights of the second cell may be a sum of the first weight $ratio_1$ to the third weight $ratio_3$.

The battery diagnosis apparatus 13 may calculate an error bound of each of the first cell to the third cell, based on the first difference values and the weights.

The battery diagnosis apparatus 13 may diagnose whether the first cell to the third cell are normal batteries or defective batteries, by comparing the error bound of each of the first cell to the third cell with the reference value. For example, the reference value may be 2.00. The battery diagnosis apparatus 13 may calculate the error bound of the first cell as 0.153846. The battery diagnosis apparatus 13 may diagnose that the first cell as a normal battery because the error round of the first cell is less than or equal to the reference value. Meanwhile, the battery diagnosis apparatus 13 may calculate the error bound of the second cell as 2.44. The battery diagnosis apparatus 13 may diagnose that the first cell as a defective battery because the error round of the second cell exceeds the reference value.

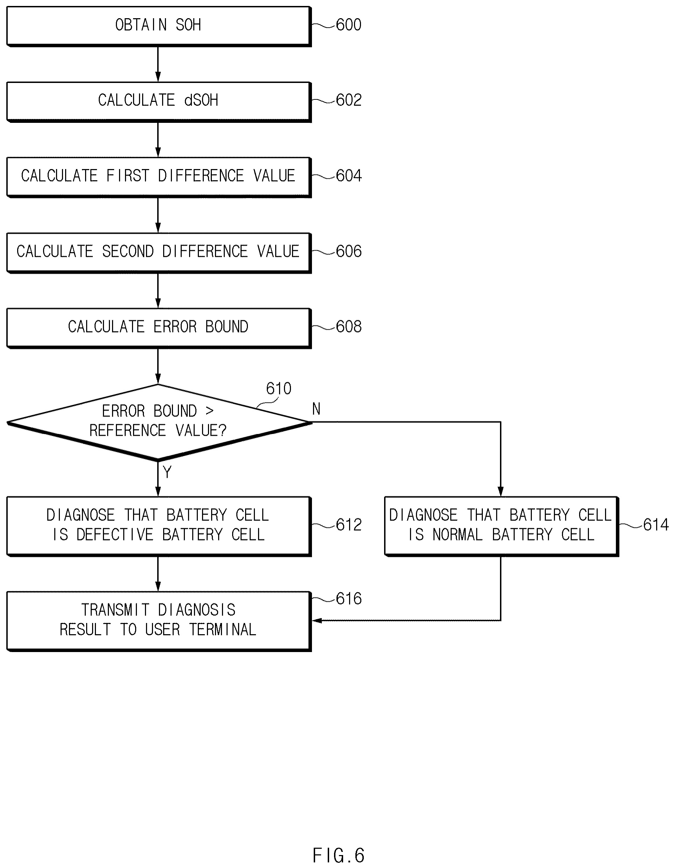

FIG. 6 is a flowchart showing an operating method of a battery diagnosis apparatus according to an embodiment of the present disclosure.

Referring to FIG. 6, in operation 600, the battery diagnosis apparatus 13 may obtain SOH values of each battery cell. The battery diagnosis apparatus 13 may measure SOH values for each battery cell in a designated cycle through the sensor 132. The battery diagnosis apparatus 13 may obtain SOH values for each battery cell measured by the sensor 132.

In operation 602, the battery diagnosis apparatus 13 may calculate SOH deviations dSOH for each battery cell.

In operation 604, the battery diagnosis apparatus 13 may calculate first difference values $\Delta dSOH$ between SOH deviations dSOH in different cycles for each of a plurality of battery cells.

In operation 606, the battery diagnosis apparatus 13 may calculate second difference values SOHdt between SOH values in different cycles for each of the plurality of battery cells.

The battery diagnosis apparatus 13 may determine the $p^{th}$ second difference value as 0 when the $p^{th}$ second difference value is a negative value. The battery diagnosis apparatus 13 may determine the greater value between the $p^{th}$ second difference value and 0 as a final $p^{th}$ second difference value, by using a max(x, y) function.

In operation 608, the battery diagnosis apparatus 13 may calculate an error bound of each of the plurality of battery cells based on the first difference values and the second difference values.

As a first process for calculating an error bound, the battery diagnosis apparatus 13 may calculate a plurality of ratios based on the second difference values to calculate the error bound.

As a second process for calculating the error bound, the battery diagnosis apparatus 13 may calculate the error bound based on the weights and the first difference values. The error bound may be calculated based on a first bound and a second bound based on the weights and the first difference values. The error bound may be calculated based on a sum of the first bound and the second bound. The first bound may be calculated based on a dot product of the first difference values and the weights.

In operation 610, the battery diagnosis apparatus 13 may compare the error bound of each battery cell with a reference value.

In operation 612, the battery diagnosis apparatus 13 may determine that a specific battery cell is a defective battery cell when an error bound of the specific battery cell exceeds the reference value.

In operation 614, the battery diagnosis apparatus 13 may determine that a specific battery cell is a normal battery cell when an error bound of the specific battery cell is less than or equal to the reference value.

In operation 616, the battery diagnosis apparatus 13 may transmit a diagnosis result to the user terminal 15. The battery diagnosis apparatus 13 may transmit a detection result to the user terminal 15 when a defective battery caused by an electrode bridge is detected. The battery diagnosis apparatus 13 may transmit a diagnosis result of classifying diagnosis target battery cells as normal battery cells or defective battery cells to the user terminal 15.

Terms such as "include", "constitute" or "have" described above may mean that the corresponding component may be inherent unless otherwise stated, and thus should be construed as further including other components rather than excluding other components. All terms including technical or scientific terms have the same meanings as those generally understood by those of ordinary skill in the art to which the embodiments disclosed herein pertain, unless defined otherwise. The terms used generally like terms defined in dictionaries should be interpreted as having meanings that are the same as the contextual meanings of the relevant technology and should not be interpreted as having ideal or excessively formal meanings unless they are clearly defined in the present document.

The above description is merely illustrative of the technical idea of the present disclosure, and various modifications and variations will be possible without departing from the essential characteristics of embodiments of the present disclosure by those of ordinary skill in the art to which the embodiments disclosed herein pertains. Therefore, the embodiments disclosed herein are intended for description rather than limitation of the technical spirit of the embodiments disclosed herein and the scope of the technical spirit of the present disclosure is not limited by these embodiments disclosed herein. The protection scope of the technical spirit disclosed herein should be interpreted by the following claims, and all technical spirits within the same range should be understood to be included in the range of the present document.

**Claims**

1. A battery diagnosis apparatus for diagnosing whether a battery is defective, the battery diagnosis apparatus comprising:

   a processor; and
   a memory storing a plurality of instructions,
   wherein the instructions cause, when executed by the processor, the battery diagnosis apparatus, to:

      calculate a state of health (SOH) deviation dSOH between an SOH in a designated cycle and an average SOH in the designated cycle, for each of a plurality of battery cells;
      calculate first difference values ΔdSOH between SOH deviations dSOH in different cycles for each of the plurality of battery cells;
      calculate second difference values SOHdt between SOH values in the different cycles for each of the plurality of battery cells;
      calculate an error bound of each of the plurality of battery cells based on the first difference values and the second difference values; and
      diagnose whether each of the plurality of battery cells is defective, based on the error bound.

2. The battery diagnosis apparatus of claim 1, wherein a $k^{th}$ first difference value $\Delta dSOH_k$ among the first difference values is an absolute value of a difference between an SOH deviation $dSOH_k$ in a $k^{th}$ cycle and an SOH deviation $dSOH_{k-1}$ in a $(k-1)^{th}$ cycle,

> k is an integer between 1 and n,
> n is an integer number of 1 or greater, and
> a $0^{th}$ cycle is the latest cycle.

3. The battery diagnosis apparatus of claim 1, wherein a $p^{th}$ second difference value $SOHdt_p$ among the second difference values is a difference value between an SOH $SOH_p$ in a $(p-1)^{th}$ cycle and an SOH $SOH_{p-l}$ in a $p^{th}$ cycle,

> p is an integer between 1 and m
> m is an integer number of 1 or greater,
> the $0^{th}$ cycle is the latest cycle, and
> a $(m+1)^{th}$ second difference value $SOHdt_{m+1}$ is a difference value between $SOH_0$ in a $0^{th}$ cycle and the $SOH_m$ in an $m^{th}$ cycle.

4. The battery diagnosis apparatus of claim 3, wherein the instructions cause, when executed by the processor, the battery diagnosis apparatus, to determine the $p^{th}$ second difference value $SOHdt_p$ as 0 when the $p^{th}$ second difference value $SOHdt_p$ is a negative value.

5. The battery diagnosis apparatus of claim 1, wherein the instructions cause, when executed by the processor, the battery diagnosis apparatus, to:

> calculate a plurality of weights based on the second difference values; and
> calculate the error bound based on the weights and the first difference values.

6. The battery diagnosis apparatus of claim 5, wherein the instructions cause, when executed by the processor, the battery diagnosis apparatus, to:

> calculate a dot product of the weights and the first difference values;
> calculate a sum of the first difference values and a product of the weights; and
> calculate the error bound by adding the calculated dot product and the calculated product.

7. The battery diagnosis apparatus of claim 1, further comprising a communication circuit,
wherein the instructions cause, when executed by the processor, the battery diagnosis apparatus, to transmit a result of the diagnosis to a user terminal through the communication circuit.

8. An operating method of a battery diagnosis apparatus, the operating method comprising:

> calculating a state of health (SOH) deviation dSOH between an SOH in a designated cycle and an average SOH in the designated cycle, for each of a plurality of battery cells;
> calculating first difference values $\Delta dSOH$ between SOH deviations dSOH in different cycles for each of the plurality of battery cells;
> calculating second difference values SOHdt between SOH values in the different cycles for each of the plurality of battery cells;
> calculating an error bound of each of the plurality of battery cells based on the first difference values and the second difference values; and
> diagnosing whether each of the plurality of battery cells is defective, based on the error bound.

9. The operating method of claim 8, wherein a $k^{th}$ first difference value $\Delta dSOH_k$ among the first difference values is an absolute value of a difference between an SOH deviation $dSOH_k$ in a $k^{th}$ cycle and an SOH deviation $dSOH_{k-1}$ in a $(k-1)^{th}$ cycle,

> k is an integer between 1 and n,
> n is an integer number of 1 or greater, and
> the $0^{th}$ cycle may be the latest cycle.

10. The operating method of claim 8, wherein a $p^{th}$ second difference value $SOHdt_p$ among the second difference values is a difference value between an SOH $SOH_p$ in a $(p-1)^{th}$ cycle and an SOH $SOH_{p-I}$ in a $p^{th}$ cycle,

   $p$ is an integer between 1 and m,
   m is an integer number of 1 or greater,
   the $0^{th}$ cycle is the latest cycle, and
   a $(m+1)^{th}$ second difference value $SOHdt_m$ is a difference value between $SOH_0$ in a $0^{th}$ cycle and the $SOH_m$ in an $m^{th}$ cycle.

11. The operating method of claim 10, further comprising determining the $p^{th}$ second difference value $SOHdt_p$ as 0 when the $p^{th}$ second difference value $SOHdt_p$ is a negative value.

12. The operating method of claim 8, wherein the calculating of the error bound of each of the plurality of battery cells based on the first difference values and the second difference values comprises:

   calculating a plurality of weights based on the second difference values; and
   calculating the error bound based on the weights and the first difference values.

13. The operating method of claim 12, wherein the calculating of the error bound based on the weights and the first difference values comprises:

   calculating a dot product of the weights and the first difference values;
   calculating a sum of the first difference values and a product of the weights; and
   calculating the error bound by adding the calculated dot product and the calculated product.

14. The operating method of claim 8, further comprising transmitting the diagnosis result to a user terminal.

ELECTRONIC DEVICE
10

BATTERY UNIT
100

BATTERY UNIT
102

•
•
•

BATTERY UNIT
104

12

BATTERY DIAGNOSIS APPARATUS
13

COMMUNICATION CIRCUIT
130

SENSOR
132

MEMORY
134

PROCESSOR
136

14

USER TERMINAL
15

FIG.1

EP 4 679 111 A1

200

|  | $SOH_0$ | $SOH_1$ | $SOH_2$ | $SOH_3$ |
|---|---|---|---|---|
| FIRST CELL | 99.9 | 99.2 | 97.5 | 96.5 |
| SECOND CELL | 99.8 | 99.3 | 96.7 | 96.5 |
| THIRD CELL | 99.7 | 99.1 | 97.6 | 96.4 |
| AVERAGE | 99.8 | 99.2 | 97.5 | 96.5 |

202

|  | $dSOH_0$ | $dSOH_1$ | $dSOH_2$ | $dSOH_3$ |
|---|---|---|---|---|
| FIRST CELL | 0.1 | 0 | 0 | 0 |
| SECOND CELL | 0 | 0.1 | 0.8 | 0 |
| THIRD CELL | 0.1 | 0.1 | 0.1 | 0.1 |

FIG.2

300

| | $\triangle dSOH_1$ | $\triangle dSOH_2$ | $\triangle dSOH_3$ | $\triangle dSOH_4$ |
|---|---|---|---|---|
| FIRST CELL | 0.1 | 0 | 0 | 0.1 |
| SECOND CELL | 0.1 | 0.7 | 0.8 | 1.6 |
| THIRD CELL | 0 | 0 | 0 | 0 |

——FIRST CELL ---SECOND CELL- ·-THIRD CELL

302

| | $SOHdt_1$ | $SOHdt_2$ | $SOHdt_3$ | $SOHdt_{tot}$ |
|---|---|---|---|---|
| FIRST CELL | 0.7 | 1.7 | 1 | 3.4 |
| SECOND CELL | 0.5 | 2.6 | 0.2 | 3.3 |
| THIRD CELL | 0.6 | 1.5 | 1.2 | 3.3 |

304

| | $ratio_1$ | $ratio_2$ | $ratio_3$ | $ratio_{tot}$ |
|---|---|---|---|---|
| FIRST CELL | 0.205882 | 0.5 | 0.294118 | 1 |
| SECOND CELL | 0.151515 | 0.787879 | 0.060606 | 1 |
| THIRD CELL | 0.181818 | 0.454545 | 0.363636 | 1 |

——FIRST CELL ---SECOND CELL- ·-THIRD CELL

FIG.3

400

| | $SOH_0$ | $SOH_1$ | $SOH_2$ | $SOH_3$ |
|---|---|---|---|---|
| FIRST CELL | 99.9 | 99.8 | 99.1 | 98.6 |
| SECOND CELL | 99.8 | 99.7 | 98.5 | 96.8 |
| THIRD CELL | 99.7 | 99.6 | 98.9 | 98.4 |
| AVERAGE | 99.8 | 99.7 | 98.9 | 96.4 |

402

| | $dSOH_0$ | $dSOH_1$ | $dSOH_2$ | $dSOH_3$ |
|---|---|---|---|---|
| FIRST CELL | 0.1 | 0.1 | 0.2 | 0.2 |
| SECOND CELL | 0 | 0 | 0.4 | 1.6 |
| THIRD CELL | 0.1 | 0.1 | 0 | 0 |

FIG.4

500

|  | △dSOH$_1$ | △dSOH$_2$ | △dSOH$_3$ | △dSOH$_4$ |
|---|---|---|---|---|
| FIRST CELL | 0 | 0.1 | 0 | 0.1 |
| SECOND CELL | 0 | 0.4 | 1.2 | 1.6 |
| THIRD CELL | 0 | 0.1 | 0 | 0 |

FIRST CELL ——— SECOND CELL - - - THIRD CELL

502

|  | SOHdt$_1$ | SOHdt$_2$ | SOHdt$_3$ | SOHdt$_{tot}$ |
|---|---|---|---|---|
| FIRST CELL | 0.1 | 0.7 | 0.5 | 1.3 |
| SECOND CELL | 0.1 | 1.2 | 1.7 | 3 |
| THIRD CELL | 0.1 | 0.7 | 0.5 | 1.3 |

504

|  | ratio$_1$ | ratio$_2$ | ratio$_3$ | ratio$_{tot}$ |
|---|---|---|---|---|
| FIRST CELL | 0.076923 | 0.538462 | 0.384615 | 1 |
| SECOND CELL | 0.033333 | 0.4 | 0.566667 | 1 |
| THIRD CELL | 0.076923 | 0.538472 | 0.384615 | 1 |

FIRST CELL ——— SECOND CELL - - - THIRD CELL

FIG.5

```
        ┌─────────────────────────────┐
        │        OBTAIN SOH           │───600
        └─────────────────────────────┘
                     │
                     ▼
        ┌─────────────────────────────┐
        │       CALCULATE dSOH        │───602
        └─────────────────────────────┘
                     │
                     ▼
        ┌─────────────────────────────┐
        │ CALCULATE FIRST DIFFERENCE VALUE │───604
        └─────────────────────────────┘
                     │
                     ▼
        ┌─────────────────────────────┐
        │ CALCULATE SECOND DIFFERENCE VALUE │───606
        └─────────────────────────────┘
                     │
                     ▼
        ┌─────────────────────────────┐
        │    CALCULATE ERROR BOUND    │───608
        └─────────────────────────────┘
                     │
                     ▼
                    610
              ╱───────────╲          N
            ╱  ERROR BOUND > ╲──────────────────┐
            ╲ REFERENCE VALUE? ╱                 │
              ╲───────────╱                      │
                   │ Y                           │
                   ▼                             ▼
    ┌─────────────────────────────┐   ┌─────────────────────────────┐
    │ DIAGNOSE THAT BATTERY CELL  │   │ DIAGNOSE THAT BATTERY CELL  │
    │  IS DEFECTIVE BATTERY CELL  │───612  │  IS NORMAL BATTERY CELL │───614
    └─────────────────────────────┘   └─────────────────────────────┘
                   │                             │
                   ▼ ───616                      │
    ┌─────────────────────────────┐             │
    │      TRANSMIT DIAGNOSIS      │◄────────────┘
    │   RESULT TO USER TERMINAL    │
    └─────────────────────────────┘
```

FIG.6

## INTERNATIONAL SEARCH REPORT

| International application No. |
|---|
| **PCT/KR2024/002076** |

**A. CLASSIFICATION OF SUBJECT MATTER**

**G01R 31/36**(2006.01)i; **G01R 31/392**(2019.01)i; **G01R 31/396**(2019.01)i; **G01R 31/382**(2019.01)i

According to International Patent Classification (IPC) or to both national classification and IPC

**B. FIELDS SEARCHED**

Minimum documentation searched (classification system followed by classification symbols)

G01R 31/36(2006.01); G01R 31/367(2019.01); G01R 31/392(2019.01); H01M 10/48(2006.01); H02J 7/00(2006.01)

Documentation searched other than minimum documentation to the extent that such documents are included in the fields searched

Korean utility models and applications for utility models: IPC as above
Japanese utility models and applications for utility models: IPC as above

Electronic data base consulted during the international search (name of data base and, where practicable, search terms used)

eKOMPASS (KIPO internal) & keywords: 배터리(battery), SOH, 평균(average), 편차(deviation), 차이값(difference value), 오류(error)

**C. DOCUMENTS CONSIDERED TO BE RELEVANT**

| Category* | Citation of document, with indication, where appropriate, of the relevant passages | Relevant to claim No. |
|---|---|---|
| A | KR 10-2021-0023695 A (LG CHEM, LTD.) 04 March 2021 (2021-03-04)<br>See claims 1-12 and figure 1. | 1-14 |
| A | KR 10-2022-0060997 A (LG ENERGY SOLUTION, LTD.) 12 May 2022 (2022-05-12)<br>See paragraphs [0081]-[0082], claim 10 and figure 9. | 1-14 |
| A | KR 10-2022-0060931 A (LG ENERGY SOLUTION, LTD.) 12 May 2022 (2022-05-12)<br>See claims 1-13 and figure 2. | 1-14 |
| A | KR 10-2014-0082750 A (KPIT TECHNOLOGIES LTD.) 02 July 2014 (2014-07-02)<br>See claims 1-10 and figure 2. | 1-14 |
| A | US 2014-0333265 A1 (PANASONIC CORPORATION) 13 November 2014 (2014-11-13)<br>See claims 16-29. | 1-14 |

☐ Further documents are listed in the continuation of Box C.　　☑ See patent family annex.

| * | Special categories of cited documents: | "T" | later document published after the international filing date or priority date and not in conflict with the application but cited to understand the principle or theory underlying the invention |
|---|---|---|---|
| "A" | document defining the general state of the art which is not considered to be of particular relevance | | |
| "D" | document cited by the applicant in the international application | "X" | document of particular relevance; the claimed invention cannot be considered novel or cannot be considered to involve an inventive step when the document is taken alone |
| "E" | earlier application or patent but published on or after the international filing date | | |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
|---|---|
| **10 May 2024** | **13 May 2024** |

| Name and mailing address of the ISA/KR | Authorized officer |
|---|---|
| **Korean Intellectual Property Office**<br>**Government Complex-Daejeon Building 4, 189 Cheongsa-ro, Seo-gu, Daejeon 35208** | |
| Facsimile No. **+82-42-481-8578** | Telephone No. |

Form PCT/ISA/210 (second sheet) (July 2022)

**INTERNATIONAL SEARCH REPORT**
Information on patent family members

International application No.

**PCT/KR2024/002076**

| Patent document cited in search report | | | Publication date (day/month/year) | Patent family member(s) | | | Publication date (day/month/year) |
|---|---|---|---|---|---|---|---|
| KR | 10-2021-0023695 | A | 04 March 2021 | EP | 4006564 | A1 | 01 June 2022 |
| | | | | JP | 2022-544857 | A | 21 October 2022 |
| | | | | JP | 7341322 | B2 | 08 September 2023 |
| | | | | US | 2022-0283234 | A1 | 08 September 2022 |
| | | | | WO | 2021-040306 | A1 | 04 March 2021 |
| KR | 10-2022-0060997 | A | 12 May 2022 | CN | 115349093 | A | 15 November 2022 |
| | | | | EP | 4102239 | A1 | 14 December 2022 |
| | | | | JP | 2023-517201 | A | 24 April 2023 |
| | | | | JP | 7427320 | B2 | 05 February 2024 |
| | | | | US | 2023-0148088 | A1 | 11 May 2023 |
| | | | | WO | 2022-097931 | A1 | 12 May 2022 |
| KR | 10-2022-0060931 | A | 12 May 2022 | | None | | |
| KR | 10-2014-0082750 | A | 02 July 2014 | CN | 103797374 | A | 14 May 2014 |
| | | | | CN | 103797374 | B | 01 February 2017 |
| | | | | EP | 2761316 | A2 | 06 August 2014 |
| | | | | JP | 2014-535037 | A | 25 December 2014 |
| | | | | JP | 6153528 | B2 | 28 June 2017 |
| | | | | US | 2014-0232411 | A1 | 21 August 2014 |
| | | | | WO | 2013-072927 | A2 | 23 May 2013 |
| | | | | WO | 2013-072927 | A3 | 18 July 2013 |
| US | 2014-0333265 | A1 | 13 November 2014 | JP | 6168301 | B2 | 26 July 2017 |
| | | | | US | 9291682 | B2 | 22 March 2016 |
| | | | | WO | 2013-145734 | A1 | 03 October 2013 |

Form PCT/ISA/210 (patent family annex) (July 2022)

**EP 4 679 111 A1**

REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- KR 1020230045996